# EUROPEAN PATENT APPLICATION

(11) **EP 1 158 294 A1**
(43) Date of publication of application: **28.11.2001**
(21) Application number: 01304241.1
(22) Date of filing: 11.05.2001
(51) Int. Cl.: G01N 21/956, G06T 7/00

(54) **A method and apparatus for inspecting printed wiring boards**

(30) Priority: 16.05.2000 GB 0011821
(71) Applicant: Lloyd Doyle Limited, Walton on Thames, Surrey KT12 3PJ (GB)
(72) Inventor: Doyle, Keith Gilbert, Walton on Tames, Surrey KT12 5LL (GB); Lloyd, Roy Anthony, Sunbury on Thames, Middlesex TW16 6PB (GB)
(74) Representative: Feakins, Graham Allan

(57) **Abstract**

Apparatus for testing a printed wiring board comprising means for optically scanning a board to be tested in two orthogonal, X-Y axes such that for each scan in the Y direction it scans a narrow strip of the board of predetermined width, w in the X direction. The optical scanning means is arranged to provide n.m discrete signals for each scan in the Y direction, wherein n is a predetermined number of signals representative of characteristics of the board across the width w of the strip (typically 1000) and m is a number dependent upon the dimension of the board to be scanned in the Y direction. Processing means is provided for processing the signals to provide signals representative of the characteristics of the board along said strip and for storing said signals. Control means is arranged to cause the scanning means repeatedly to scan the board in the Y direction and to step it a predetermined amount in the X direction at the end of each scan until a required area of the board has been scanned and the processing means has processed a plurality of said groups of signals. The processing means is further arranged to identify common areas of each conductive track such that at the completion of a test, the storage means contains information representative of the X-Y co-ordinates of a plurality of datum areas and of the said datum areas which are interconnected. The datum areas may be edge connectors, pads and the like. The processor means comprises a plurality of processors, each processor being operative to process data of a corresponding ribbon of a scanned strip, the scanned strip being divided into a plurality of ribbons.

## Description

### Technical Field

This invention relates to a method and apparatus for inspecting pattern on a substrate such as a pattern on a printed wiring board.

### Background

It is known from GB 2143944B to provide apparatus for testing a printed wiring board comprising means for optically scanning a board to be tested in two orthogonal, X-Y axes such that for each scan in the Y direction it scans a narrow strip of the board of predetermined width, w in the X direction, the scanning means being arranged to provide n.m discrete signals for each scan in the Y direction, wherein n is a predetermined number of signals representative of characteristics of the board across the width w of the strip and m is a number dependent upon the dimension of the scan in the Y direction, such that the n.m signals are representative of the characteristics of the board at the corresponding n.m positions along the strip, and processing means for processing the signals to provide signals representative of the characteristics of the board along said strip and means for storing said signals, control means arranged to cause the scanning means repeatedly to scan the board in the Y direction and to step it a predetermined amount in the X direction at the end of each scan until a required area of the board has been scanned and the processing means has processed a plurality of said groups of signals, the processing means being further arranged to identify common areas of each conductive track such that at the completion of a test, the storage means contains information representative of the X-Y co-ordinates of a plurality of datum areas and of the said datum areas which are interconnected.

The board is scanned as a series of strips as shown in Fig. A.

In that known technique, labelling is carried out by a data processor for the whole of each strip, the labels for the right hand column of a first strip are stored in RAM, and they are then read out while a second strip is scanned, and used to determine the labels for the left hand column of the second strip and so on. This has the disadvantage that only a single dataflow processor can be used, limiting the attainable speed of data processing.

### Statements of Invention

In the present invention, a plurality of data processors are provided, each data processor being operative at a time to process data of a corresponding portion of a scanned strip, the scanned strip comprising a plurality of portions.

In the preferred embodiments, there is an advantage of an increase in processing speed proportional to the number of data processors provided.

Preferably each of the processors comprise interconnection analyser means arranged to determine which datum areas are connected together and to provide output information to a storage means, the output information being stored as a wiring list of datum areas interconnected by track, in which the wiring list is produced by integrating wiring lists for said portions of a strip by correlating data from the edge of a respective first portion and the adjacent edge of a respective second portion.

Preferably the portions of a strip are parallel, and of substantially equal width in the X direction. Preferably, the portions are each of the same length as the strip.

The datum areas preferably comprise terminations in the board such that at the end of a test the stored information is equivalent to a wiring list of interconnected datum areas.

The terminations can comprise mounting pads for components, via-hole positions, points on power planes and/or points on ground planes, of a board.

The processing means preferably comprise means for comparing the stored signals with a plurality of signals representative of the required interconnections for the board (the required wiring list) thereby to test the quality of the board.

The apparatus preferably comprises track contraction means for processing preselected areas of each group of n1 x ml signals in such a manner as to determine whether the width of a conductor at any point along its length is less than a predetermined minimum width.

The apparatus preferably further comprises track expansion means arranged to process the scanned signals in such a manner as to determine whether the spacing between adjacent conductors at any point along their length is less than a predetermined value.

Further according to the invention there is provided a process for testing a printed wiring board comprising the steps of optically scanning a board to be tested in two orthogonal, X-Y axes such that for each scan in the Y-direction a narrow strip of predetermined width, w, in the X direction is scanned, deriving n.m discrete signals for each scan in the Y direction, wherein n is a predetermined number of signals representative of characteristics of the board across the width w of the strip and m is a number dependent upon the dimension of the scan in the Y direction such that the n.m signals are representative of the characteristics of the board at the corresponding n.m positions along the strip, and digitally processing the signals to provide signals representative of the characteristics of the board along said strip and storing said signals, scanning the board repeatedly in the Y direction and stepping it a predetermined amount in the X direction at the end of each scan until a required area of the board has been scanned and a plurality of said groups of signals has been processed, and identifying common areas of each conductive track such that at the completion of a test, information representative of the X-Y co-ordinates of a plurality of datum areas and of the said datum areas which are interconnected are stored as a wiring list, in which the digital processing comprises dividing data from a scanned strip into a plurality of groups of data each group corresponding to a portion of the scanned strip, and parallel-processing at least two of said groups of data.

### Detailed Description of the Preferred Embodiments

Preferred embodiments of the invention will now be described by way of example with reference to the accompanying drawings, in which:
Fig. 1 is a block schematic diagram of an apparatus according to the invention for testing a printed wiring board,
Fig. 1a is a block schematic diagram of a dataflow processor as shown in Fig. 1,
Fig. 1b is a schematic illustration of scanning a board as a series of strips;
Fig. 1c is a schematic illustration of data for each strip being processed as a number of narrower ribbons,
Fig. 2 is a simplified, perspective view of a scanning means suitable for use with the apparatus of Fig. 1,
Fig. 3 is a simplified view of an optical arrangement and an optical scanning device suitable for use with the Figs. 1 and 2 apparatus,
Fig. 4 is a simplified representation of a multiple delay circuit for use in the apparatus of Fig. 1,
Fig. 5 is a part of a table showing the outputs of the circuits of Fig. 4,
Fig. 6 is a simplified lock circuit diagram of a track contraction, or expansion, circuit of Fig. 1,
Fig. 7 is a simplified drawing illustrating the processing of a group of n1 X m1 signals by the circuit of Fig. 6,
Figs. 8 to 11 are tables for use in describing the operation of an interconnection analyser,
Figs. 12 and 13 are flow charts illustrating part of the operation of an interconnection analyser,
Fig. 14 is a block diagram of a label allocation request generation circuit,
Fig. 15 is a block circuit diagram of an interconnection analyser,
Figs. 16 and 17 are block diagrams of circuits for use in the circuit of Fig. 15,
Fig. 18 is a block diagram of an edge transition detection circuit,
Fig. 19 is a block diagram of the termination pulse generator shown in Figure 1a.

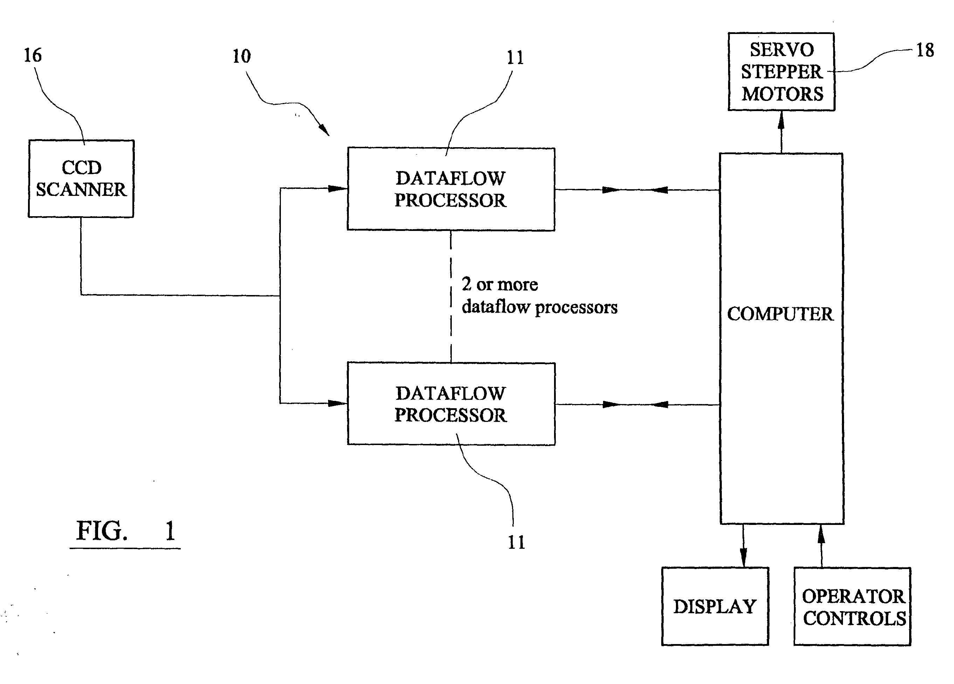

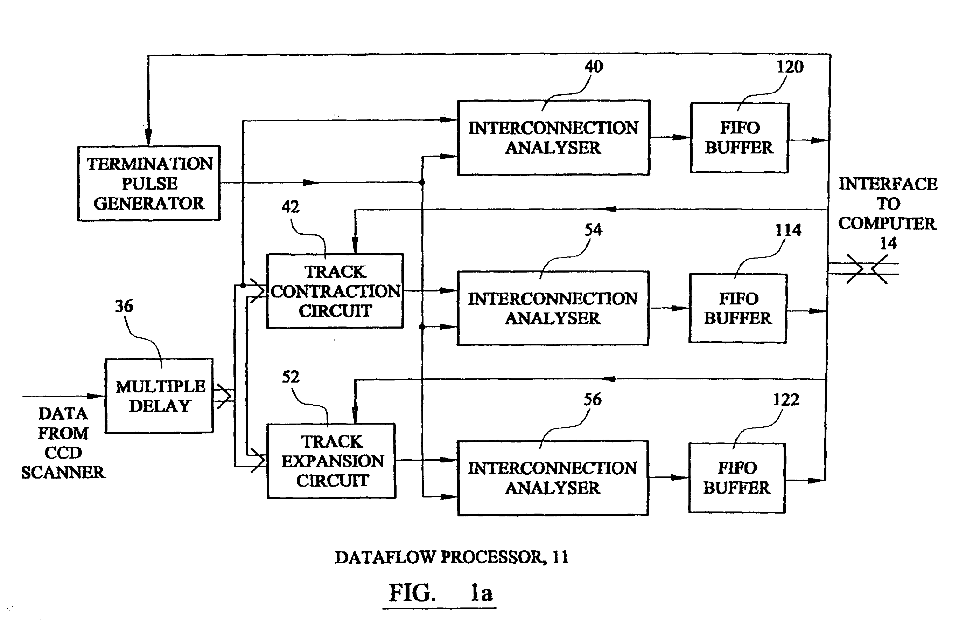

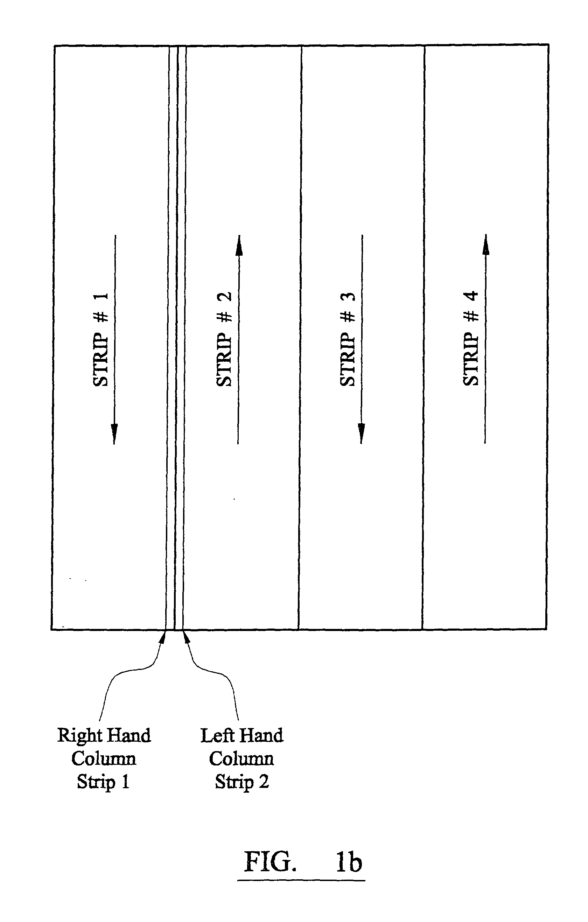

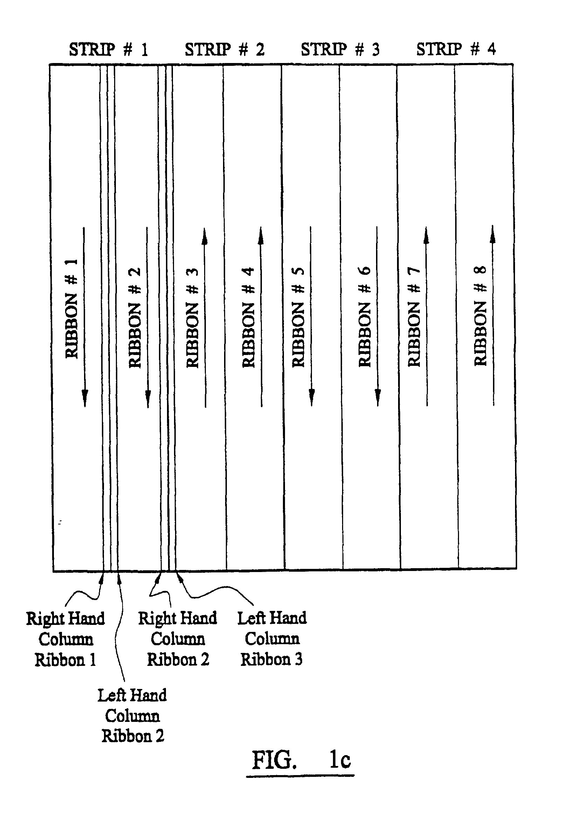

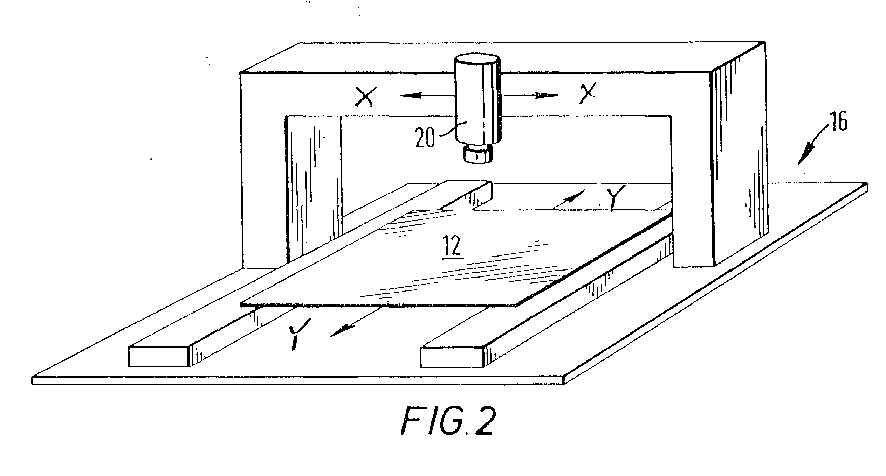

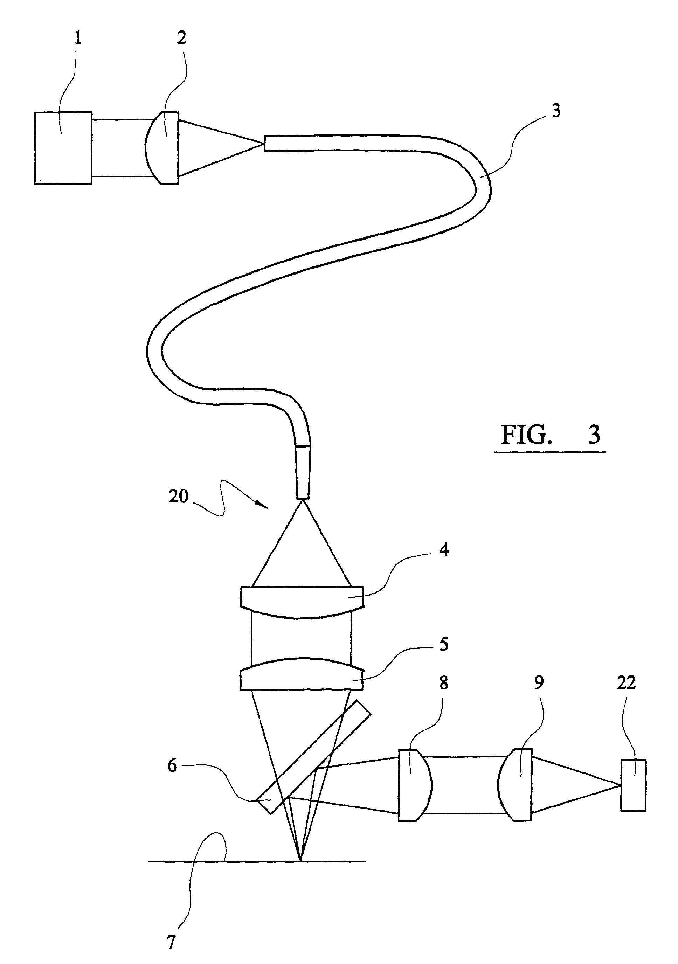

Referring to the drawings, in Fig. 1 there is shown an apparatus 10 for testing the wiring of a printed wiring board 12 (Figs. 2 and 3). The apparatus 10 includes two similar dataflow processors 11, the internals of which are shown in Fig. 1a. In other embodiments there are more than two such dataflow processors 11.

A printed circuit board being inspected is scanned as a series of strips as shown in Fig. 1b. For processing data of each strip each strip is considered and is divided into two 'ribbons', as shown in Fig. 1c, and data of each ribbon is labelled using a separate dataflow processor 11. A ribbon is a portion of a strip such that the two or more ribbons constituting each strip are parallel, of equal width, and the same length as the strip. Because the second dataflow processor 11, 11a does not have access to the labels generated by the first dataflow processor 11, 11b, and vice versa, the technique of storing the labels for the edge columns in RAM and reading them out again is not used. Rather, processing is achieved by labelling each ribbon as though it were isolated from the rest of the board, and then linking the resulting wiring lists together in software.

This is illustrated in Fig. 1c, where the strips of Fig. 1b are each split into two ribbons. The first dataflow processor 11a processes ribbons marked 1, 3, 5 & 7, and the second dataflow processor 11b processes ribbons marked 2, 4, 6 & 8. The locations of transitions in the right hand column of ribbon 1 and the left hand column of ribbon 2 are used to determine how to link together the wiring lists for these two ribbons, and then the locations of transitions in the right hand column of ribbon 2 and the left hand column of ribbon 3 are used to determine how to link the wiring list for ribbon 3 to the composite wiring list for ribbons 1 & 2 and so on, until the wiring list for the complete board is obtained.

In alternative embodiments more than two dataflow processors 11 are provided, each strip being divided into a corresponding number of ribbons such that a data processor processes a corresponding ribbon.

The apparatus 10 is controlled by a computer 14, which also includes various storage elements such as random access memories (RAM's) for use in the operation of the apparatus and the storage of information for use in testing a board 12.

The apparatus 10 comprises an optical scanner 16 which is controlled by servo/stepper motors 18 to traverse backwards and forwards across the surface of the board 12 in the Y direction and after each traversal it is moved relative to the board a predetermined distance in the X direction.

Fig. 2 shows a simple arrangement for such a scanner 16, in which the optical scanning device 20 can be traversed backwards and forwards in the Y direction while the board 12 can be stepped a discrete distance in the X direction between each Y traversal. Other arrangements are of course possible, for example the board 12 could be moved on an X-Y table moveable in both orthogonal axes with the device 20 fixed in position or the board 12 could be mounted in a fixed position and the scanning device 20 mounted for movement in the X-Y directions.

Fig. 3 shows a simplified side view of an optical scanning device 20, utilising a charge coupled device (CCD) camera 22.

As shown in Fig. 3, light from a lamp 1 is focussed by a lens 2 onto a fibre optic cable 3. The other end of the fibre optic cable 3 is formed so that the light emerges from a slit-shaped region. This region is imaged by two lenses 4, 5 through a partially silvered beamsplitter 6 on to a surface 7. Light scattered by the surface 7 is reflected off the beamsplitter 6 and imaged by two lenses 8, 9 onto the CCD 22.

The surface 7 of the board 12 is imaged by the lenses 8, 9 on to the charge-coupled device 22, which contains a linear array of photosites together with circuitry for reading out the light levels from each photosite.

In this embodiment there are 4096 photosites arranged to scan a strip about 40 mm wide in the X direction as the board 12 is scanned in the Y direction, i.e. each photosite is responsive to a 10 micron X 10 micron area (a pixel).

Thus the linear array of photosites effectively produces a parallel output containing 4096 analogue pieces of information in the X direction. As the board is scanned in the Y direction the array continues to develop 4096 output signals at discrete position 10 microns apart for the complete scan in the Y direction.

The 4096 signals from the CCD scanner device 16 representing a strip 40 mm long in the X direction and 10 microns wide in the Y direction are coupled serially to the input of a threshold circuit 34 having a threshold reference voltage input.

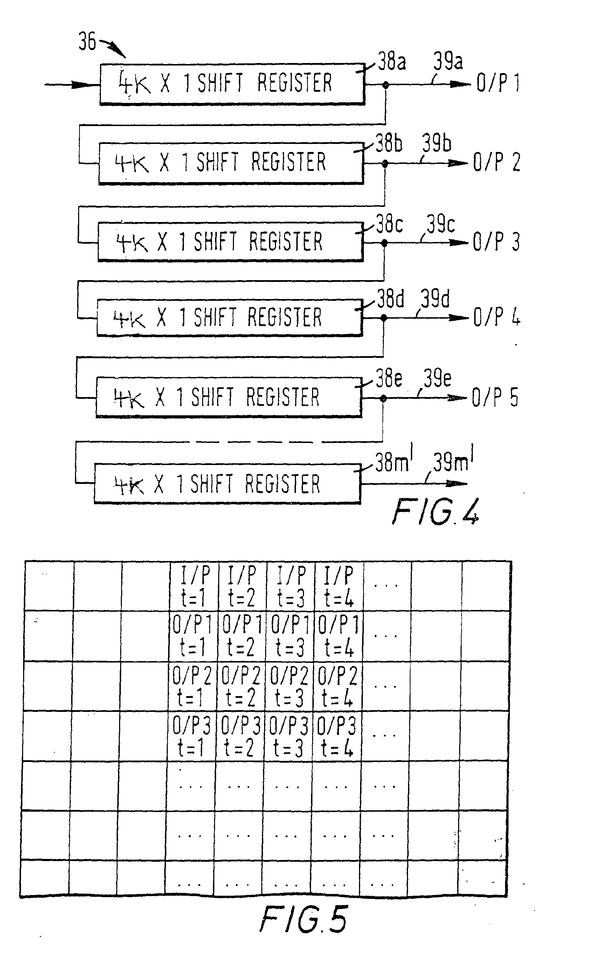

The binary stream of information indicative of track (i.e. conductor) and non-track (i.e. insulating substrate) pixel areas appearing at output 34b is fed to a multiple delay circuit 36. The circuit 36 is implemented using random access memories (RAM's) for low cost, but can be considered conceptually, and for ease of description, as a set of shift registers 38 each one of which feeds the next as shown in Fig. 4.

Each shift register 38 is 4096 bits long so that at time t=4096 the first shift register 38a could be regarded as containing a full 4096 bits of information in one 40 mm wide strip of the area being scanned. At time t=8192 the first 4096 bits of information will have been shifted serially into shift register 38b and shift register 38a will contain the next succeeding 4096 bits of information and so on.

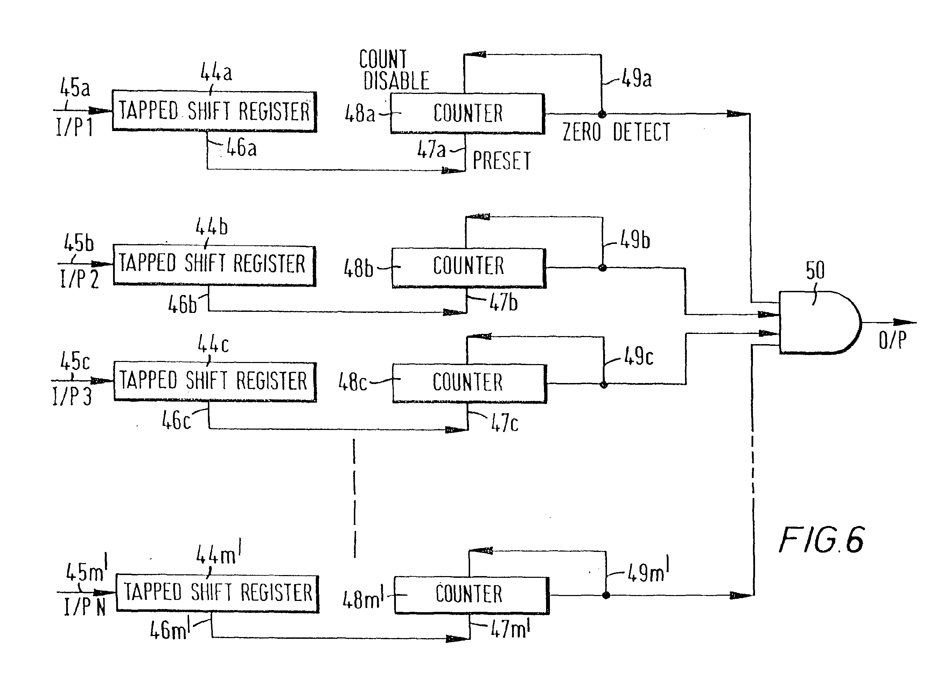

As the delay through each shift register is equal to one scan line in the X direction the parallel outputs 39a to 39m' of the shift registers 38a to 38m' at any time can be regarded as m' bits of information in a row in the Y direction of scan. Thus the outputs of the shift registers represent a parallel scan across the width of the scan, as shown in part in the table of Fig. 5.

The parallel output signals from the multiple delay circuit 36, that is the outputs 39a to 39m' are coupled in parallel to a pair of circuits 42, 52 whose function is to determine for each point in the scanned image whether it is within a preset distance of a track or non-track area. The circuit 42 is called a track contraction circuit and the circuit 52 a track expansion circuit; the track expansion circuit 52 is similar to the track contraction circuit 42 with the exception that its input and output signals are inverted. Any one of the outputs of the multiple delay circuit 36 (for preference the middle one of the 39a to 39m') is also fed to the interconnection analyser 40.

The interconnection analyser 40, to be described hereinafter, is coupled through a first-in, first-out buffer 120 to the computer 14. Its function is to produce a set of signals to be stored which are a representation of a wiring diagram for the printed wiring board 12, that is it provides a set of X-Y co-ordinate signals representative of terminations in the board and edge connector areas, if any, labelled to indicate which terminations are interconnected. A termination is a point on a circuit feature, such as the centre of a component mounting pad, a place on the printed circuit where a via-hole is intended to be drilled.

The track contraction circuit 42 will now be described with reference to Fig. 6. The circuit 42 comprises a plurality of tapped shift registers 44a to 44m' having inputs 45a to 45m' coupled to the outputs 39a to 39m' respectively of the shift registers 38. Each circuit 44 has a programmable, tapped output 46a to 46m' which is coupled to the preset input 47a to 47m' of a presettable down counter 48a to 48m' respectively. The taps on the shift registers 44 are under the control of the computer 14.

In a practical embodiment m'=40 so that there are forty shift registers 38 and 44 and the shift registers 44 are forty bits long (that is n'=40) so that the set of shift registers 44 at any one time contain information equivalent to an area 40 X 40 bits (or pixels) square, although it will be realised that, in operation, bits of information are being shifted in parallel through the various registers at clock rate. Thus at a given instant the information contained in the shift registers 44 can be regarded as a digital image of part of the board. The contraction circuit 42 is arranged to determine whether or not all of the bits in the shift registers 44 which would fit in a circle of radius R, where R is equal to half the minimum specified track width, are a binary '1' to indicate track. The value of R is predetermined for the board 12 and its value is set into the computer by the operator. For example in the 40 X 40 matrix of shift registers 44, the value of R could be made equal to 20 and it would be possible to look at the bits of the individual cells of the shift registers to determine their value. If each cell was provided with an output an individual AND gate could be coupled to various cells in a particular shift register and the outputs of the individual AND gates coupled to the inputs of another AND gate so that if, and only if, all of the individual cells contained a binary '1' then the output of the final AND gate would be a '1' to indicate a complete track in the area of radius R. However if only a single cell was set to '0' then the output of the final AND gate would be zero indicating that the track was not entirely complete at the area being tested at that instant in time.

In the example given using forty shift registers, each forty bits long the first and fortieth shift registers could be tapped at, say cells 20 and 21, the middle twentieth and twenty first shift registers could have every cell tapped and connected to an associated input of two forty input AND gates. The shift registers two to nineteen would have progressively more cells tapped and the registers twenty-two to thirty-nine would have progressively fewer cells tapped so that the outputs from the tapped cells would approximate to a circle of radius R. However this arrangement would be expensive in AND gates and quite complex and somewhat difficult to vary in practice and the circuit of Fig. 6 was devised.

In Fig. 6 the taps on the shift registers 44 can be set automatically by the computer 14 under the control of the operator and it will be seen that they are variable delays, the delay being a maximum (20 bits) for the first and fortieth shift registers 44 and a minimum (zero) for, say, the twentieth and twenty-first. The delays for shift registers 2 to 19 decrease progressively from 19 to 1 bits and for shift registers 22 to 39 increase progressively from 1 to 19 bits. The counters 48a to 48m' can be preset to a count determined by its position, i.e. for the first and fortieth counters the preset count would be a minimum value (say 1 or 2) and for the twentieth and twenty-first counters to a maximum value (say 40). The other counters are preset to values increasing and decreasing in the same way as the delays through the shift registers 44 decrease and increase.

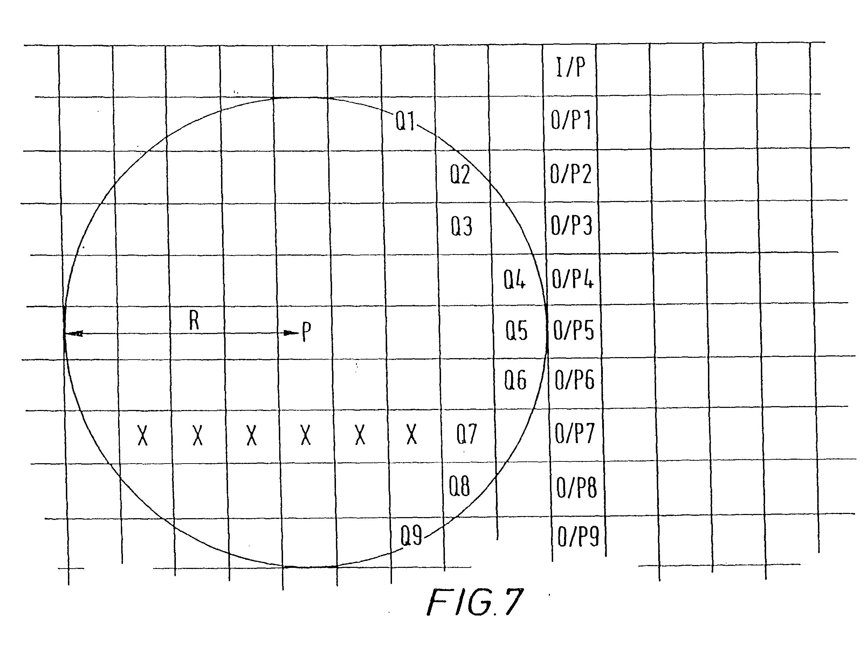

Fig. 7 is a diagrammatic representation of a simplified circuit of Fig. 6 having nine preset shift registers 44. each nine bits long. At the instant shown in Fig. 7, the circuitry is determining whether there are any non-track areas within a distance R from the point P. Each circuit 44, 48 determines whether there are any non-track areas along a corresponding strip such as that marked XXXXXXX and the outputs of all of the counters 48 are combined in AND gate 50 to provide a single output; '1' if all of the counter outputs indicate track; '0' if any one or more of the counter outputs indicate the presence of a non-track area. In the example shown the seventh counter 48g would be preset to a count of seven whenever a non-track element is seen at position Q7. The counter is then counted down to zero so that if all of the elements marked X contain track, i.e. are at '1' then the output of the counter will go to '1'. This disables further counting of the counter 48g via line 49g until the counter is preset again. The output of AND gate 50 will thus go high '1' if and only if all of the elements within a distance R of P contain track. The output of the AND gate is thus a serial representation of an image similar to that arriving at the threshold circuit 34, except that it has been delayed, and the track areas have been "thinned down" in accordance with the minimum track width settings. Thus, if the track is complete but does not meet the minimum track width requirements at any point along its length, for example if there is a nick or a flaw in it the output of AND gate 50 will go to zero at this point. This information will be processed in an interconnection analyser 54 and the output fed to the computer 14 via a FIFO buffer 114.

The track expansion circuit 52 is similar to the track contraction circuit 42 with the exception that the input to it and the output from it are inverted. It is thus caused to consider track as non-track and vice versa. In this case if the value R is made half the minimum allowable spacing between conductors then if the spacing is adequate the output of its AND gate (equivalent to AND gate 50) will be a series of '1's but if the spacing at any position on the board is less than the minimum allowable the output of the AND gate will go to '0'. The information from the track expansion circuit will be processed in an interconnection analyser 56 and the output fed to the computer 14 via the FIFO buffer 122.

The above explanation has been considerably simplified as if the information is static but it should be realised that the information is being shifted through the shift registers at clock frequency and the testing is taking place continuously on the fly.

Also it will be remembered that the image is 4096 bits wide in the X direction and although the delay shift registers 38 are 4096 bits long the shift registers 44 are only n'=40 bits long. Thus at say t=4096p where p is an integer the circuit 42 may be inspecting rows 1 to 40 in the X direction, at t=(4096p + 1 clock pulse) rows 2 to 41 and so on.

As mentioned the train of output signals from the circuits 42, 52 are processed by interconnection analysers 54, 56 respectively.

The function of the interconnection analyser is to determine which terminations are connected together to form a wiring list which is stored in the computer.

For a good board the wiring lists compiled by the circuits 54, 56 i.e. the "thinned" and "fattened" images respectively, should be the same but if there are any narrow cuts, nicks, pinholes or inadequate spacing between conductors the two wiring lists will differ. They can also be compared with a wiring list obtained from the CAD data, for the board or from a known good board the CAD data being the information describing the desired configuration of the board, in machine readable format. Alternatively, or in addition they can be compared with a wiring list prepared from the interconnection analyser 40 which, in effect provides a basic list of the various complete interconnections but regardless of the presence of nicks, pinholes or the like, provided that the circuit is complete and regardless of the spacing between conductors provided that they do not actually touch.

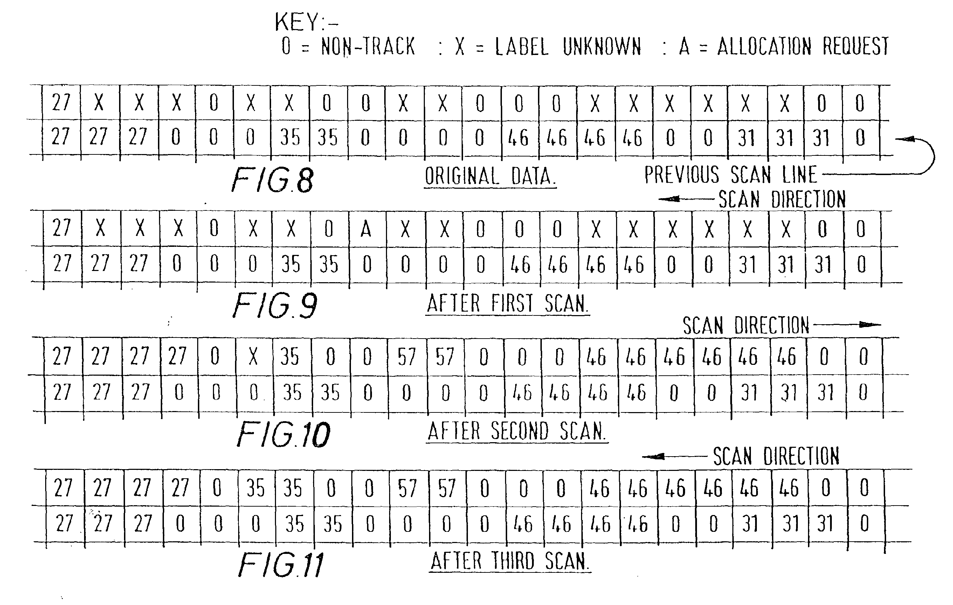

The interconnection analysers 54, 56 scan the data streams from the track contraction circuit 42 and the track expansion circuits 52 respectively and associate a "label" with each track area. These labels are binary numbers, which are allocated in sequence whenever a "new" piece of track is scanned. When a termination pulse occurs, the label of the corresponding piece of track is passed to the computer. When two pieces of track which have been given different labels converge, so that they are known to be connected together, the two labels concerned are passed to the computer with the information that they are interconnected. The edge of a band 4096 bits wide X m bits long is defined by the final, or 4096^{th}, bit in each 4096 bits across the width w of the band. The labelling process is carried out in three stages as illustrated in the tables of Figs. 8, 9, 10 and 11. In each of these figures, the lower line represents labels that have been determined for the previous scan line, and the upper line represents the labels that have been determined so far for the scan line that is currently being labelled. The data for this scan line is traversed three times before all the labels are correctly allocated. The first traversal is from right to left, and serves only to identify any region of track which does not touch any regions of track in the previous line, and which will therefore require a new label to be allocated to it.

In the Figures individual areas of track are allocated a code, in which:
O represents a non-track area.
X represents a track area to which a label is to be allocated.
A represents an area where a label request signal has been generated.
A two digit number e.g. 27 represents a label which has been allocated to a track area.

Referring to Fig. 8, as mentioned the lower line shows part of a scanned line which has been labelled and, reading from left to right, the first track areas have been labelled as track areas 27, the next three areas are non-track, the next two areas have been labelled as track areas 35 and so on.

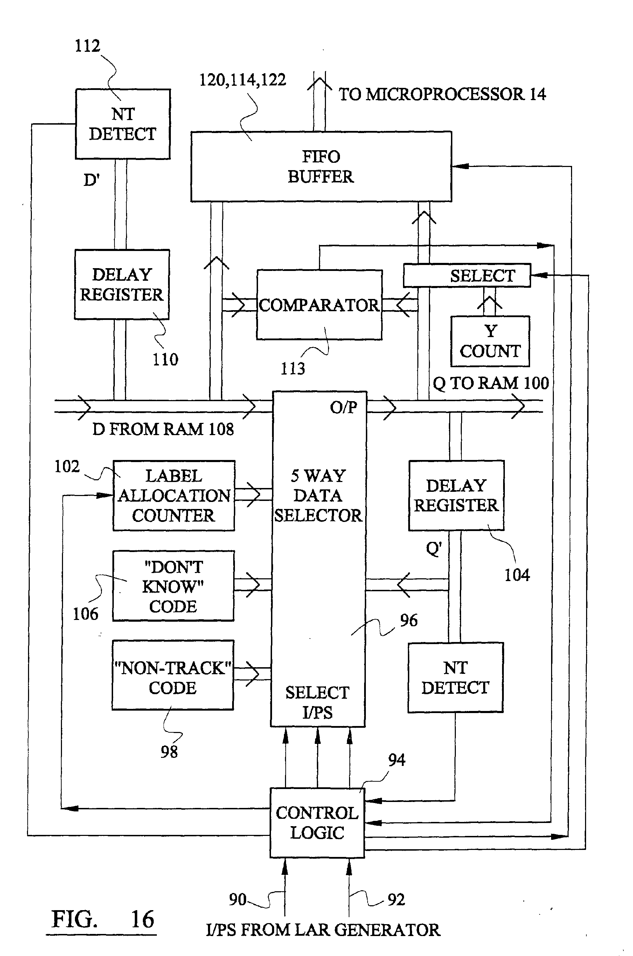

The labels are allocated by a label allocation counter (Fig. 16) and are coupled as 16 bit words to the computer 14 when a termination pulse occurs or when a "collision" (to be defined hereinafter) occurs.

The first label allocation traversal is from right to left as shown in Fig. 9 and, as mentioned, serves to identify areas of track which do not touch any areas of track in the lower, immediately proceeding scanned track.

If it identifies such track it allocates a label allocation request A in the first non-track area that occurs after that particular piece of track. In Fig. 9 there are two such adjacent areas at positions 10 and 11 from the left. As the data is being traversed from right to left the first available non-track area is position 9 and this is allocated a label allocation request A as shown.

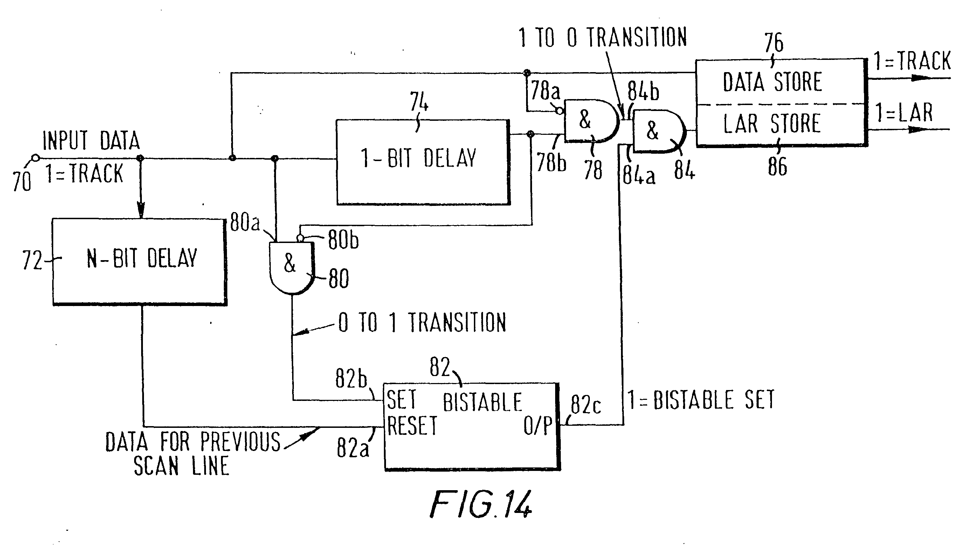

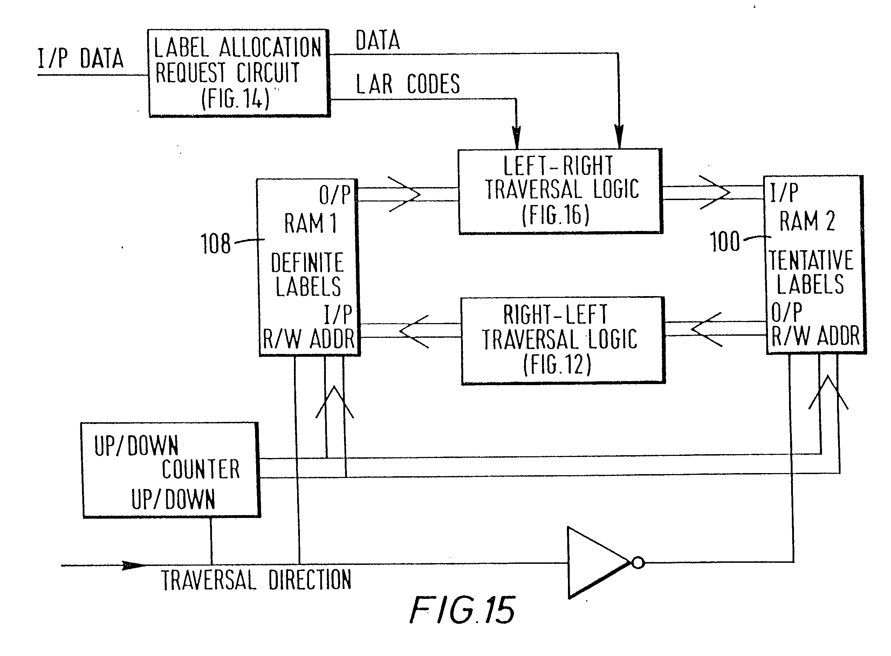

A circuit for performing this function is shown in Fig. 14.

Referring to Fig. 14, input data in serial form and representing the 4096 bits of information of a scanned line is coupled from the output of the track contraction circuit 42 to an input 70 of the interconnection analyser 54. A similar circuit to that of Fig. 14 is used in the interconnection analysers 40 and 56 and so the operation in relation to these circuits will not be discussed in detail.

The stream of data coupled to input 70 is coupled to an n-bit delay 72 (n=4096), a 1-bit delay 74, an n bit data store 76, to the inverting input 78a of an AND gate 78, and to input 80a of an AND gate 80.

The output of the 4096 bit delay 72 and the AND gate 80 are coupled to reset and set inputs 82a, 82b of a bistable circuit 82. Thus current data bits corresponding to the track/non-track areas in the upper row of Fig. 9 are coupled to the set input 82b of the bistable circuit 82 and the corresponding data from areas in the previous scan line are fed to the reset input 82a of the bistable circuit 82. So long as the input data is representative of non-track i.e. '0' the AND gate 80 has '0' on input 80a and a '0' on the line to input 80b due to the 1-bit delay through delay 74 which is inverted to present a '1' input to the AND gate 80. Thus as soon as a piece of track is encountered the corresponding '1' bit on input 80a causes the AND gate 80 to provide a '1' on the input 82b to set the bistable circuit 82, which provides a '1' at the output 82c. If the next piece of input data is a '1' representative of track the input at 80a is a '1' but the previous '1' input delayed 1-bit arrives at the input 80b is inverted and the output of AND gate 80 returns to "zero".

The effect of this is that as soon as a piece of track is encountered at input 70 the output of AND gate 80, is at '1' for one clock pulse duration.

The delay circuit 72 being 4096 bits long is effectively providing information about the area of track immediately below the area currently being examined. If the area in the lower row is also track then a '1' will be applied to the reset input of bistable 82 to reset its output to '0'. However if the output of the delay 72 is '0' representing non-track then the bistable will remain set and a '1' will be applied to input 84a of AND gate 84. However, while the input 70 is receiving track signals the '1' signals fed to inverting input 78a keep the output of AND gate 78 at '0' and thus inhibit the AND gate 84. As soon as the input reverts to non-track '0' the output of AND gate 78 goes to '1' and a '1' is fed into the 4096 bit allocation request store 86. This '1' bit is fed into store in the first non-track area after the track to non-track transition. For example in Fig. 9 where scanning is taking place from right to left, track is located at position 11 from the left which is not adjacent to a piece of track in the previously scanned lower row and a label must be allocated to it. This '1' coupled to input 80a and the '0' from the 1-bit delay 74 will provide a '1' on the output of AND gate 80 to set the bistable 82. However the AND gate 84 will be inhibited by the corresponding '1' on the inverting input of AND gate 78. The next '1' input at position 10 from the left will be coupled to AND gate 80 but its output will return to '0' because the previous '1' from position 11 delayed 1-bit in delay 74 will appear at inverting input 80b. Thus bistable 82 remains set but can be reset if a '1' appears at input 82a. At position 9 from the left in Fig. 9 the input signal at 70 reverts to non-track '0' and this coupled to inverting input 78a of AND gate 78 removes the inhibit signal from AND gate 84 and allows a '1' into the label allocation request store 86. This is shown as A in Fig. 9 and as aforementioned appears in the first non-track area after a piece of track to which a label has not been allocated.

Thus the data store 76 contains the 4096 bits of information of the scanned line and the LAR store 86 contains a series of '0' and a '1' at the position immediately to the left of an isolated piece of track to which a label has not been allocated and which is not adjacent to a piece of track in the line previously scanned.

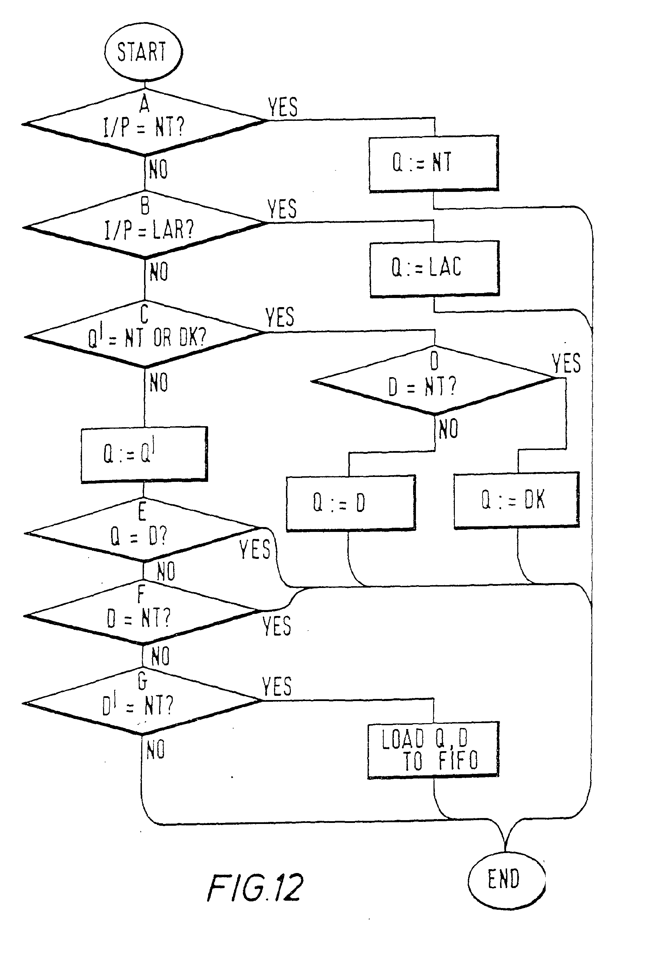

The stores 76, 86 are bidirectional so that data can be read out from left to right during the next traversal (Fig. 10) so that at position 9 from the left a label allocation request is fed from store 86 to a label allocation counter (to be described in relation to Figs. 12 and 16) which allocate a new label, in this case 57, to the track areas 10 and 11 from the left and updates the label allocation counter to the next label to be allocated.

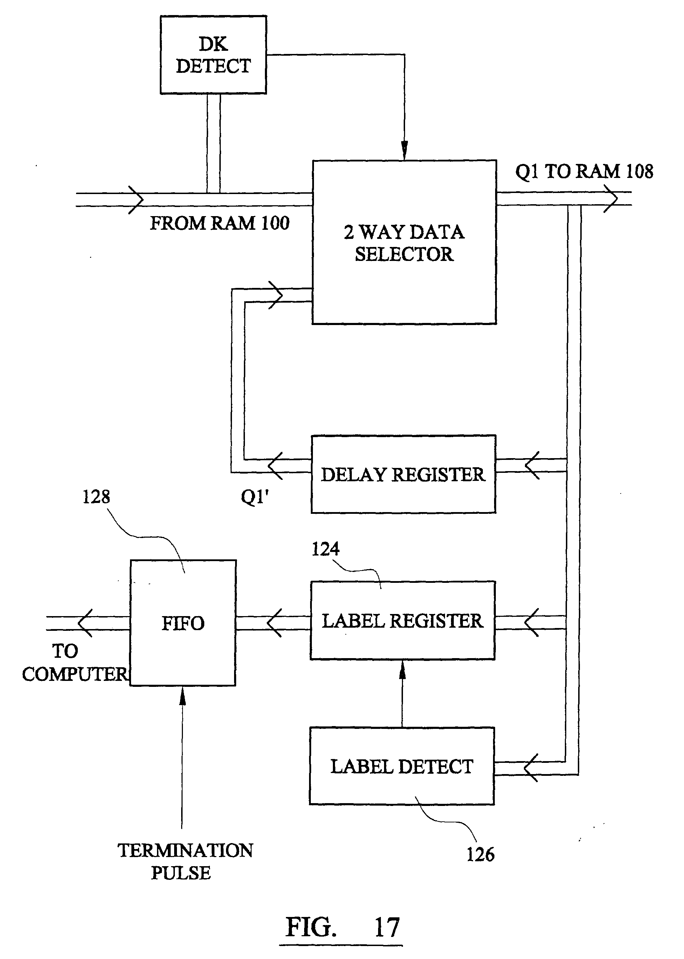

Also during this traversal from left to right, the track areas are labelled up as far as possible by reference to the labels in adjacent elements. Some elements may be impossible to label at this stage, and they are identified by a special 'Don't Know' code, so that they can be resolved during the third traversal, for example the track at position 6 from the left in Fig. 10 because it is adjacent to an area of non-track in the previous line immediately below it. The labels for the previous scan line are held in a RAM 108 marked RAM' in Fig. 15, and the 'left-right traversal circuit' uses these to generate a set of labels including 'Don't Knows' in the RAM 100 marked RAM 2 in Fig. 15. During the third traversal these values are transferred back to RAM 1 by the 'right-left traversal circuit' Fig. 17 which also replaces any 'Don't Knows' by the correct labels.

The output from the 4096 bit data store 76, being a series of '0' and '1' representing non-track and track, is coupled to a data input terminal 90 of circuit Fig. 16. Likewise, the output from the label allocation request (LAR) Store 86, being a series of '0' but containing a '1' for each new label to be allocated is coupled to input terminal 92 of Fig. 16.

The logic of the left-right traversal is shown in the flow chart of Fig. 12. Non-track elements are labelled with 'non-track' code. If a 'label allocation request' code is encountered, a new label is obtained from the label allocation counter (Fig. 16). Other elements are labelled by reference to the adjacent elements. In the situations shown below the element marked ? is a track element which is to be labelled, L1 & L2 are differing labels and a 0 represents a non-track element. The various possibilities are as follows:

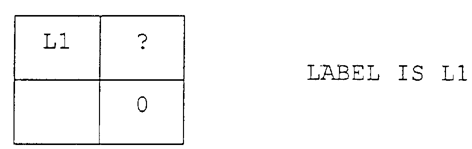

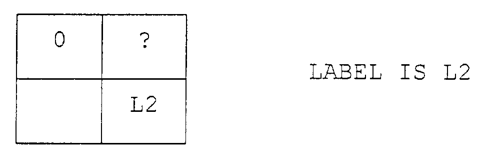

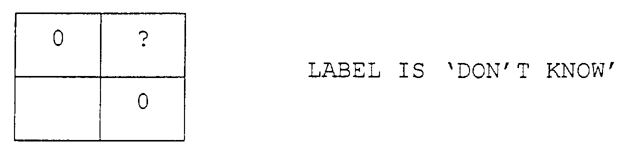

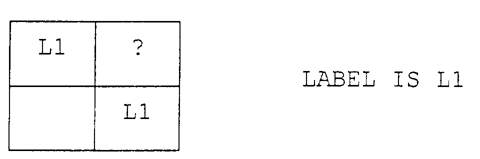

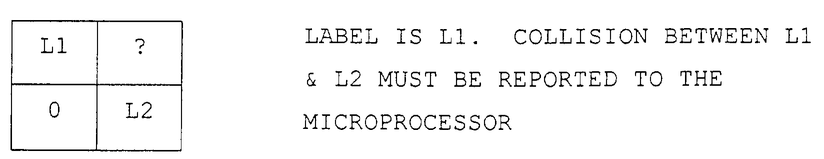

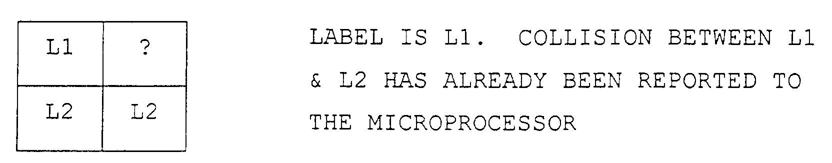

The flowchart of Fig. 12 represents the logical paths, which must be followed to obtain these results, where the corresponding symbols are:

| | |
|---|---|
| Q' | Q |
| D' | D |

when
Q is the name of the box to be filled in.
Q' is the name of the box in the same scan line as Q but 1 place to the left.
D is the name of the box underneath Q. i.e. in the last scan line.
D' is the name of the box underneath Q'. i.e. in the last scan line.
I/P is the input from the bidirectional shift registers in the Label Allocation Request Generator.
NT is the code for 'Non-Track'.
LAR is the code for 'Label Allocation Request'.
DK is the code for 'Don't Know'
LAC is the output of the Label Allocation Counter.

Referring to Figs. 16 and 12, data input is coupled to input 90 and label allocation request input is coupled to input 92 of a control logic circuit 94.

In Fig. 12 each bit of data is interrogated to enquire if it is track or non-track (NT); interrogation (A) if it is NT the action is allocate Q = NT and in Fig. 16 this is achieved by way of the control logic 94 which sets a five way data selector 96 to couple a 16-bit non-track code from circuit 98 to the input of RAM 100 (Fig.15).

If the input is track then it is interrogated (B) to determine whether there is also a label allocation request signal on input 92. If there is, the logic circuit 94 couples the output of a label allocation counter 102 to the RAM 100, and then increments the counter 102 to the next label address.

If there is not a label allocation request the flow chart enquires whether Q', the Q in the previously interrogated area is non-track (C). If Q' was track then Q is a continuation of the track and the label allocated to Q' must also be allocated to Q. This is achieved by coupling the output of a delay register 104 which is holding Q' to the RAM 100 by way of the data selector 96. If Q' was non-track, the interrogation is, was D non-track (D). If it was NT then it is not yet possible to allocate an address label to Q and it is therefore allocated a 'Don't Know' code from circuit 106. As before the 'Don't Know' code is coupled to RAM 100 by way of data selector 96. If D was track, then Q is allocated the same label as D (Q = D) and the appropriate D label is taken from RAM 108 by way of data selector 96 to RAM 100.

If Q is track and Q' is track (interrogation C) and Q was made equal to Q' then the next interrogation is, does Q = D (interrogation E) if it does then no further action is necessary (Q having been correctly labelled). If however Q is not equal to D then the next question (interrogation F) is, is D = NT (non-track) if it is then again no further action is necessary (Q having been correctly labelled). If however D is track and not equal to Q then there is a situation in which both Q and D are track elements which have been allocated different labels although they are in fact touching. This is termed a "collision" in this specification and is detected by comparator 113. It is necessary to report this collision to the computer 14. To save storage space in the computer it is only necessary to report the first instance of a collision and so the next interrogation (G) is, is D' = NT if it is then this must be the first instance of this collision and the control circuitry will then load the label Q and the label D to the microprocessor 14 via the FIFO store 114. If D' is equal to track then the collision must have been reported previously and therefore no further action is necessary. Such a collision is illustrated at position 19 from the left in Fig. 10 where labels 46 and 31 have been allocated to the same piece of track.

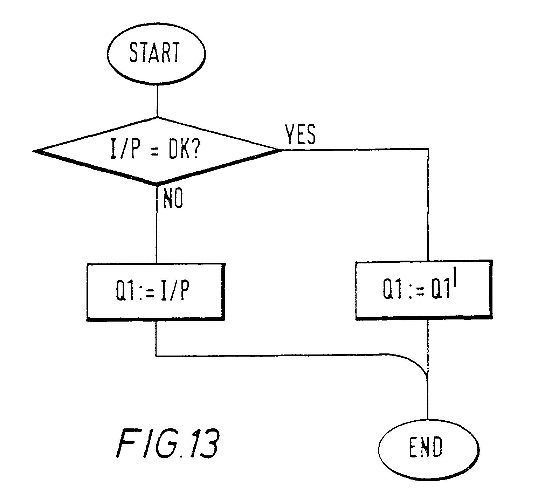

During the third traversal Fig. 11, the labels are read out from RAM 100 and any 'Don't Knows' are set to the same label as the element on their right by the 'right-left traversal circuit' Fig. 17 before they are written back into RAM 108, in accordance with the flow chart of Fig. 13. Such a 'Don't Know' was shown at position 6 from the left in Fig. 10 and in Fig. 11 it will be seen that it has been allocated label 35. The corresponding symbols for this flowchart are reversed, so that Q1' is the name of the box in the same scan line as Q1 but one place to the right.

| | |
|---|---|
| Q1 | Q1' |
| D1 | D1' |

The interconnection analysers 40 and 56 operate in a similar way to that of the analyser 54 but the data input in the case of analyser 56 is, in effect, the data after "track expansion" as hereinbefore described and in the case of analyser 40 it is unmodified data.

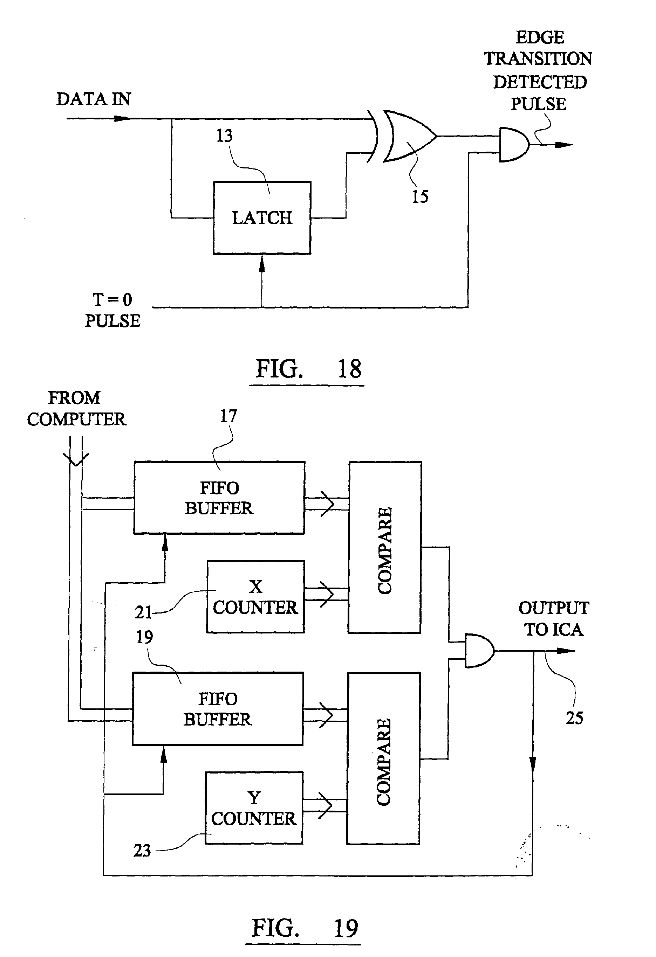

An edge transition detection circuit (Fig. 18) is provided as part of the control logic 94 of each interconnection analyser. The inputs to this edge transition detection circuit are the input data to the respective interconnection analyser and a signal which is pulsed when the first pixel of each line is being fed to the respective interconnection analyser. A latch 13 is enabled by this pulse, so that its output changes on the trailing edge of the pulse to match the data on the input during that pulse. An 'exclusive or' gate 15 compares the output of the latch 13 with the input, and outputs a '1' whenever they differ. This signal is gated with the timing pulse, so that an output pulse is generated whenever a pixel is found in the left hand column of the current row which differs from that in the left hand column of the preceding row. An identical circuit is used for the right hand column, but with the timing pulse occurring at T = 4095. Whenever one of these signals occurs, the corresponding label is fed to the corresponding FIFO buffer, together with the Y co-ordinate of the row, and a bit indicating whether the event occurred at the left or right hand column.

The termination pulse generator 35 is shown in more detail in Fig. 19 and is used to generate 'termination' pulses. When one of these pulses occurs, the current labels in the respective interconnection analysers 40 are fed to their FIFO buffers 120, 14, 122, together with a bit indicating that the data corresponds to a termination. The timing of the termination pulses is arranged so that the termination pulses correspond to points in the image representing component mounting pads, places where via holes will be drilled etc. The information to determine these termination points is obtained from a CAD system, as the information is the same as that which would be required to, for example, build a fixture for a 'bed of nails' electrical tester, or to program an automatic drilling machine to drill the via holes in the board.

The computer sorts the data into the order in which the (X, Y) co-ordinates will be encountered during scanning i.e. firstly by increasing Y (or decreasing Y if the strip is to be scanned in the reverse direction), and secondarily by increasing X. The sorted data is downloaded to the FIFOs 17, 19 from the computer. During scanning, the X counter 21 is incremented for each pixel and reset at the end of each line, and the Y counter 23 is incremented at the end of each line. Whenever the X and Y counts agree with those in the FIFO buffers 17, 19 a termination pulse 25 is output to the interconnection analysers 40, 54, 56 and the data of the next termination is shifted to the output of the next FIFO buffers 17, 19.

The information fed to the computer 14 from the interconnection analyser 40 via the FIFO buffer 120 is sufficient to enable a wiring list to be generated indicating which terminations are connected to which other terminations, and this can be compared with the wiring list obtained from a known good board so that differences between the two can be indicated to the operator in the same way as with a 'bed-of-nails' tester. The wiring lists obtained for the 'thinned' and 'fattened' images by way of analysers 54 and 56 and their respective FIFO buffers 114 and 122 can also be compared to determine the presence of partial breaks and shorts.

The wiring list for the entire panel is determined from the data stored in the FIFO buffer 120 by the technique known as 'linked list processing', in which data is stored in the computer as records, each of which contains a data value and a pointer, which provides a link to another such record. Initially all links are cleared i.e. nil. As the data is read from the FIFO buffer 120 records are created for each label and termination. If the entry in the buffer 120 was caused by a termination pulse, a link is created between a termination record and the corresponding label record. If the entry in the buffer was caused by a 'collision', a link is created between two label records. If the entry in the buffer 120 was caused by a left-hand edge transition, a link is created between the label record and the label record for the corresponding edge pixel in the adjacent ribbon. If the entry in the buffer was caused by a right-hand edge transition, the data is used to update an array recording the labels in the right-hand column for use when the next ribbon is processed.

Once all the links have been created, the records for the labels can be deleted from the linked lists, leaving only the records for the terminations. These can be compared against the linked lists obtained from the CAD data or a known good board as discrepancies between the two linked lists indicate a break or short circuit in the printed circuit board being inspected. Similarly the linked lists obtained from the interconnection analysers 54 and 56 can be compared against the linked list obtained from interconnection analyser 40 with discrepancies indicating partial breaks or near-shorts respectively.

To explain this further, turning back to Fig. 1c, whenever a new track area is found adjacent to the previously scanned ribbon, a label allocation request is generated.

For each edge of the ribbon being processed, the data for each edge pixel is compared against the data of the previous column, and whenever a track-to-nontrack or nontrack-to-track transition occurs, a report is sent to the same FIFO buffer as the one used for collisions. This report contains the label of the pixel, the 'Y' position along the strip, the edge (left or right) where the transition occurred, and whether it was track-to-nontrack or non-track-to-track transition. This information is used to integrate the wiring lists for all the ribbons. The software determines the wiring list for each ribbon, and then uses the edge reports to merge the wiring list into a wiring list for the entire image. Since labels cannot propagate from one ribbon to another, the label allocation counters are reset at the start of each strip.

## Claims

**1.** Apparatus for testing a printed wiring board comprising means for optically scanning a board to be tested in two orthogonal, X-Y axes such that for each scan in the Y direction it scans a narrow strip of the board of predetermined width, w in the X direction, the scanning means being arranged to provide n.m discrete signals for each scan in the Y direction, wherein n is a predetermined number of signals representative of characteristics of the board across the width w of the strip and m is a number dependent upon the dimension of the scan in the Y direction, such that the n.m signals are representative of the characteristics of the board at the corresponding n.m positions along the strip, and processing means for processing the signals to provide signals representative of the characteristics of the board along said strip and means for storing said signals, control means arranged to cause the scanning means repeatedly to scan the board in the Y direction and to step it a predetermined amount in the X direction at the end of each scan until a required area of the board has been scanned and the processing means has processed a plurality of said groups of signals, the processing means being further arranged to identify common areas of each conductive track such that at the completion of a test, the storage means contains information representative of the X-Y co-ordinates of a plurality of datum areas and of the said datum areas which are interconnected, in which the processing means comprises a plurality of processors, each processor being operative at a time to process data of a corresponding portion of a scanned strip, the scanned strip comprising a plurality of portions.

**2.** Apparatus according to claim 1 wherein each of the processors comprise interconnection analyser means arranged to determine which datum areas are connected together and to provide output information to a storage means, the output information being stored as a wiring list of datum areas interconnected by track, in which the wiring list is produced by integrating wiring lists for said portions of a strip by correlating data from the edge of a respective first portion and the adjacent edge of a respective second portion.

**3.** Apparatus according to claim 1 or claim 2, in which the portions of a strip are parallel, and of substantially equal width in the X direction.

**4.** Apparatus according to any preceding claim wherein the processor means is operative to process the signals in groups of n' x m' where n' is less than or equal to n and m' is less than or equal to m.

**5.** Apparatus according to any preceding claim wherein the datum areas comprise terminations in the board.

**6.** Apparatus according to claim 5 wherein the datum areas comprise mounting pads for components, via-hole positions, points on power planes and/or points on ground planes, of a board.

**7.** Apparatus according to any preceding claim, wherein the processing means comprises mean for comparing the stored signals with a plurality of signals representative of the required interconnections for the board (the required wiring list) thereby to test the quality of the board.

**8.** Apparatus according to any preceding claim, wherein the optical scanning means is arranged to generate a series m of output signals as the board is scanned in the Y direction, each output signal comprising n analogue information signals representative of the said characteristics of the board across the width w of the strip.

**9.** Apparatus according to claim 8, wherein the n analogue information signals are coupled serially to the input of threshold circuit means arranged to determine from each information signal the characteristics of the board at the position on the board corresponding to the information signal and to provide a digital signal representative of track or non-track.

**10.** Apparatus according to any preceding claim, wherein the processing means comprises track contraction means for processing preselected areas of each group of n' x m' signals in such a manner as to determine whether the width of a conductor at any point along its length is less than or greater than a predetermined minimum width and to provide an output indicative thereof.

**11.** Apparatus according to claim 10, wherein the output of the track contraction means is coupled to an input of first interconnection analyser means arranged to determine which datum areas are connected together and to provide output information to a storage means, the output information being stored as a wiring list of datum areas interconnected by track of width equal to or greater than the said minimum specified track width.

**12.** Apparatus according to claim 11, wherein the output of the track contraction means in n-bit serial form representative of track or non-track is coupled to the input of a label allocation request circuit in the interconnection analyser means arranged to identify each discrete area of track and allocate a label thereto from a label allocation counter, such that at the end of a test, the labels associated with the datum areas are stored in said storage means.

**13.** Apparatus according to claim 12, wherein the interconnection analyser comprises means for determining when two tracks having different labels converge and for coupling an information signal to the storage means that the said tracks are interconnected.

**14.** Apparatus according to claim 12 or 13, wherein the label allocation request circuit is arranged to scan said n bits of information in a scan line a plurality of times; in a first scan in one direction the circuit is arranged to identify each region of track which does not touch a region of track in the immediately preceding scan line to provide a label allocation request (LAR) signal in the first non-track area after the identified track region such that at the end of the first scan a data store contains the n-bits of scanned information and a label allocation request store contains the LAR signal in the said first non-track area; in the second scan in an opposite direction , an LAR signal from the LAR store is coupled to the label allocation counter which couples a provide output information to a storage means, the output information being stored as a wiring list of datum areas interconnected by track, in which the spacing between adjacent tracks at any point along their length is equal to or greater than the said predetermined value.

**18.** Apparatus according to claim 17, wherein the output of the track expansion means in n-bit serial form representative of track or non-track is coupled to the input of a label allocation request circuit in the second interconnection analyser means arranged to identify each discrete area of track and allocate a label thereto from a label counter, the label associated with each data area being coupled to a storage means, such that at the end of a test, the labels are stored in said storage means.

**19.** Apparatus according to claim 18, wherein the interconnection analyser comprises means for determining when two tracks having different labels converge and for coupling an information signal to the storage means that the said tracks are interconnected.

**20.** Apparatus according to claim 18 or 19, wherein the label allocation request circuit is arranged to scan said n bits of information in a scan line a plurality of times; in a first scan in one direction the circuit is arranged to identify each region of track which does not touch a region of track in the immediately preceding scan line to provide a label allocation request (LAR) signal in the first non-track area after the identified track region such that at the end of the first scan a data store contains the n-bits of scanned information and a label allocation request store contains the LAR signal in the said first non-track area, in the second scan in an opposite direction, an LAR signal from the LAR store is coupled to a label allocation counter which couples a label address to the corresponding identified track region in the n-bit scan line and is updated one count, other unlabelled track areas are provided with label addresses corresponding to the addresses of adjacent track areas, and remaining unlabelled track areas are allocated a "don't know" code; and in the third scan areas previously allocated a "don't know" code are provided with a label address corresponding to that in the immediately preceding area.

**21.** Apparatus according to any one of claims 11 to 20 wherein the digital information comprising the wiring list in the storage means coupled to the output of the first interconnection analyser means is compared under the control of the microprocessor with digital information corresponding to a required wiring list to determine whether the board under test is within acceptable limits as to track widths.

**22.** Apparatus according to any one of claims 15 to 20, wherein the digital information comprising the wiring list in the storage means coupled to the output of the second interconnection analyser means is compared under the control of the microprocessor with digital information corresponding to a required wiring list to determine whether the board under test is within acceptable limits as to track spacings.

**23.** Apparatus according to claim 21 or 22, wherein the wiring lists in the storage means coupled to the first and second interconnection analyser means are compared to determine whether the board is within acceptable limits as to track widths and spacings.

**24.** Apparatus according to any of claims 21 to 23, wherein the required wiring list is derived from a known good board.

**25.** Apparatus according to any one of the preceding claims, wherein the processing means comprises a third interconnection analyser means having its input coupled to the output of the temporary storage means and its output coupled to a storage means thereby to store a basic wiring list of the board irrespective of the width of and spacing between tracks.

**26.** Apparatus according to any one of claims 21 to 24, wherein the required wiring list is derived from the storage means coupled to the third interconnection means as claimed in claim 25.

**27.** Apparatus according to any one of claims 11 to 26, wherein the processing means further comprises termination detection circuit means having an input coupled to the output of said threshold circuit means and an output coupled to the input of the or each interconnection analyser means, the termination detection circuit means being arranged to generate a termination output signal when the digital data signals from the threshold circuit correspond to the termination on the board, and the storage means coupled to the or each interconnection analyser means is arranged to store the X-Y co-ordinate of each termination.

**28.** Apparatus for testing a printed circuit board substantially as hereinbefore described.

**29.** A process for testing a printed wiring board comprising the steps of optically scanning a board to be tested in two orthogonal, X-Y axes such that for each scan in the Y-direction a narrow strip of predetermined width, w, in the X direction is scanned, deriving n.m discrete signals for each scan in the Y direction, wherein n is a predetermined number of signals representative of characteristics of the board across the width w of the strip and m is a number dependent upon the dimension of the scan in the Y direction such that the n.m signals are representative of the characteristics of the board at the corresponding n.m positions along the strip, and digitally processing the signals to provide signals representative of the characteristics of the board along said strip and storing said signals, scanning the board repeatedly in the Y direction and stepping it a predetermined amount in the X direction at the end of each scan until a required area of the board has been scanned and a plurality of said groups of signals has been processed, and identifying common areas of each conductive track such that at the completion of a test, information representative of the X-Y co-ordinates of a plurality of datum areas and of the said datum areas which are interconnected are stored as a wiring list, in which the digital processing comprises dividing data from a scanned strip into a plurality of groups of data each group corresponding to a portion of the scanned strip, and parallel-processing at least two of said groups of data.

**30.** A process for testing a printed wiring board substantially as hereinbefore described.
